(19) Europäisches Patentamt
European Patent Office
Office européen des brevets

(11) **EP 3 252 902 A1**

(12) **EUROPÄISCHE PATENTANMELDUNG**

(43) Veröffentlichungstag:
06.12.2017 Patentblatt 2017/49

(51) Int Cl.:
*H02H 1/00* (2006.01)   *G01R 31/12* (2006.01)

(21) Anmeldenummer: 17171304.3

(22) Anmeldetag: 16.05.2017

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(30) Priorität: **31.05.2016 DE 102016209443**

(71) Anmelder: **Siemens Aktiengesellschaft**
**80333 München (DE)**

(72) Erfinder:
• **Wenzlaff, Karsten**
**01097 Dresden (DE)**
• **Meyer, Jörg**
**01157 Dresden (DE)**
• **Schegner, Peter**
**01259 Dresden (DE)**

(54) **STÖRLICHTBOGENERKENNUNGSEINHEIT**

(57) Die Erfindung betrifft eine Störlichtbogenerkennungseinheit für einen elektrischen Niederspannungsstromkreis, aufweisend mindestens einen dem Stromkreis zugeordneten Spannungssensor, zur periodischen Ermittlung von elektrischen Spannungswerten (um) des Stromkreises, mindestens einen dem Stromkreis zugeordneten Stromsensor, zur periodischen Ermittlung von elektrischen Stromgrößen des Stromkreises, die beide mit einer Auswerteeinheit verbunden sind, und die derart ausgestaltet sind, dass fortlaufend Wertepaare, aufweisend einen Spannungswert und eine Stromgröße, ermittelt werden, dass ein Wertesatz mehrere Wertepaare umfasst, dass aus drei Wertesätzen eine Lichtbogenspannung (Ulb) berechnet wird, die mit einem ersten Schwellwert (SW1) verglichen wird und bei dessen Überschreitung ein Störlichtbogenerkennungssignal abgegeben wird.

FIG 2

EP 3 252 902 A1

**Beschreibung**

Die Erfindung betrifft eine Störlichtbogenerkennungseinheit, einen Leistungsschalter, einen Kurzschließer und ein Verfahren zur Störlichtbogenerkennung.

In Niederspannungsstromkreisen bzw. Niederspannungsanlagen respektive Niederspannungsnetzen, d.h. Stromkreise für Spannungen bis 1000 Volt Wechselspannung oder 1500 Volt Gleichspannung, sind Kurzschlüsse meist mit auftretenden Störlichtbögen, wie parallele oder serielle Störlichtbögen, verbunden. Besonders in leistungsstarken Verteil- und Schaltanlagen können diese bei einer nicht ausreichend schnellen Abschaltung zu verheerenden Zerstörungen von Betriebsmitteln, Anlagenteilen oder kompletten Schaltanlagen führen. Um einen länger andauernden und großflächigen Ausfall der Energieversorgung zu vermeiden und Personenschäden zu reduzieren, ist es erforderlich derartige Störlichtbögen, insbesondere stromstarke bzw. parallele Störlichtbögen, in wenigen Millisekunden zu erkennen und zu löschen. Konventionelle Schutzsysteme von Energieversorgungsanlagen (z.B. Sicherungen und Leistungsschalter) können unter den geforderten zeitlichen Anforderungen keinen zuverlässigen Schutz bieten.

Mit Leistungsschalter sind hier insbesondere Schalter für Niederspannung gemeint. Leistungsschalter werden, insbesondere in Niederspannungsanlagen, üblicherweise für Ströme von 63 bis 6300 Ampere eingesetzt. Spezieller werden geschlossene Leistungsschalter, wie Moulded Case Circuit Breaker, für Ströme von 63 bis 1600 Ampere, insbesondere von 125 bis 630 oder 1200 Ampere eingesetzt. Offene Leistungsschalter bzw. Luftleistungsschalter, wie Air Circuit Breaker, werden insbesondere für Ströme von 630 bis 6300 Ampere, spezieller von 1200 bis 6300 Ampere eingesetzt.

Leistungsschalter im Sinne der Erfindung können insbesondere eine elektronischen Auslöseeinheit, auch als Electronic Trip Unit, kurz ETU, bezeichnet, aufweisen.

Leistungsschalter überwachen den durch sie hindurchfließenden Strom und unterbrechen den elektrischen Strom bzw. Energiefluss zu einer Energiesenke bzw. einem Verbraucher, was als Auslösung bezeichnet wird, wenn Stromgrenzwerte oder Strom-Zeitspannengrenzwerte, d.h. wenn ein Stromwert für eine gewisse Zeitspanne vorliegt, überschritten werden. Die Ermittlung von Auslösebedingungen und das Auslösen eines Leistungsschalters können mittels einer elektronischen Auslöseeinheit erfolgen.

Kurzschließer sind spezielle Einrichtungen zum Kurzschließen von Leitungen bzw. Stromschienen, um definierte Kurzschlüsse zum Schutz von Stromkreisen bzw. Anlagen herzustellen.

Konventionelle Störlichtbogendetektionssysteme werten die durch den Lichtbogen erzeugte Lichtemission aus und detektieren hiermit den Störlichtbogen.

Dies hat den Nachteil, dass parallel zu den elektrischen Leitungen bzw. Stromschienen Lichtwellenleiter bzw. optische Detektionssysteme verlegt werden müssen, um eventuell auftretende Störlichtbögen zu erkennen.

Aufgabe der vorliegenden Erfindung ist es, eine Möglichkeit zur Störlichtbogenerkennung aufzuzeigen.

Diese Aufgabe wird durch eine Störlichtbogenerkennungseinheit mit den Merkmalen des Patentanspruchs 1, einen Leistungsschalter gemäß Patentanspruch 31, einen Kurzschließer gemäß Patentanspruch 32 und ein Verfahren mit den Merkmalen des Patentspruchs 33 gelöst.

Erfindungsgemäß ist vorgesehen, dass eine Störlichtbogenerkennungseinheit für einen elektrischen Niederspannungsstromkreis mindestens einen dem Stromkreis zugeordneten Spannungssensor, zur periodischen Ermittlung von elektrischen Spannungswerten (um) des Stromkreises, mindestens einen dem Stromkreis zugeordneten Stromsensor, zur periodischen Ermittlung von elektrischen Stromgrößen des Stromkreises, aufweist, die beide mit einer Auswerteeinheit verbunden sind, und die derart ausgestaltet sind, dass fortlaufend Wertepaare, aufweisend einen Spannungswert und eine Stromgröße, ermittelt werden. Ein Wertesatz umfasst mehrere Wertepaare und aus mindestens zwei Wertesätzen wird eine Lichtbogenspannung berechnet, die mit einem ersten Schwellwert verglichen wird und bei dessen betragsmäßiger Überschreitung wird ein Störlichtbogenerkennungssignal abgegeben.

Mit betragsmäßiger Überschreitung ist eine Überschreitung gemeint, bei der hinsichtlich eines positiven ersten Schwellwertes einer Überschreitung oder/und eines negativen vierten Schwellwertes eine Unterschreitung erfolgen könnte, analog zu einem betragsmäßigen Vergleich der Lichtbogenspannung mit einem (positiven) Schwellwert, welche natürlich auch erfolgen kann.

Die Sensoren können dabei extern angeordnet sein und müssen nicht im Gehäuse der Störlichtbogenerkennungseinheit angeordnet sein. Die periodische bzw. fortlaufende Ermittlung von Wertepaaren eines Spannungswertes und einer Stromgröße, insbesondere zu einem Zeitpunkt, kann beispielsweise durch eine Abtastung der entsprechenden Werte erfolgen.

Dies hat den besonderen Vorteil, dass eine einfache und sichere Möglichkeit zur Störlichtbogenerkennung gegeben ist.

Vorteilhafte Ausgestaltungen der Erfindung sind in den Unteransprüchen angegeben.

In einer vorteilhaften Ausgestaltung der Erfindung erfolgt die Berechnung der Lichtbogenspannung aus drei Wertesätzen. Dies hat den besonderen Vorteil, dass eine besonders genaue Ermittlung der Lichtbogenspannung ermöglicht wird, um so sicherer Störlichtbögen zu erkennen.

In einer vorteilhaften Ausgestaltung der Erfindung ist die elektrische Stromgröße entweder ein elektrischer

Stromwert ($i_m$) oder ein Wert für die Änderung des elektrischen Stromes nach der Zeit ($i'_m$). Dies hat den besonderen Vorteil, dass nur eine Stromgröße, entweder Stromwert oder Änderung des elektrischen Stromes nach der Zeit, respektive die Ableitung des Stromes nach der Zeit, ermittelt werden braucht. Beispielsweise kann vorteilhaft zur Ermittlung der Stromgröße eine Rogowskispule verwendet werden, womit die Änderung des Stromes nach der Zeit erfasst wird.

In einer vorteilhaften Ausgestaltung der Erfindung wird im Falle der Ermittlung des elektrischen Stromwertes ($i_m$) daraus ein Wert für die Änderung des elektrischen Stromes nach der Zeit ($i'_m$), respektive die erste Ableitung des Stromwertes nach der Zeit, ermittelt oder im Falle der Ermittlung des Wertes für die Änderung des elektrischen Stromes nach der Zeit ($i'_m$) daraus der elektrische Stromwert ($i_m$) ermittelt. Ein Wertepaar weist damit vorteilhafterweise einen Spannungswert ($u_m$), einen Stromwert ($i_m$) und einen Wert für die Änderung des Stromes nach der Zeit ($i'_m$) auf, womit sich die Lichtbogenspannung ($U_{lb}$) berechnen lässt. Die drei Werte eines Wertepaares können auch parallel ermittelt, abgetastet bzw. gemessen werden.

In einer vorteilhaften Ausgestaltung der Erfindung ist die Auswerteeinheit derart ausgestaltet, dass die Berechnung der Lichtbogenspannung ($U_{lb}$) mit Hilfe einer Integralgleichung oder deren Lösung durchgeführt wird.

Dies hat den besonderen Vorteil, dass eine umfassende Berechnungsmöglichkeit unter Berücksichtigung vieler Parameter eines realen Stromkreises zur Verfügung steht.

In einer vorteilhaften Ausgestaltung der Erfindung ist die Auswerteinheit derart ausgestaltet, dass ein Wertepaar nur einem Wertesatz zugeordnet ist.

Dies hat den besonderen Vorteil, dass eine besonders genaue Berechnung ermöglicht wird, da Redundanzen der ermittelten Wertepaare in verschiedenen Wertesätzen ausgeschlossen werden.

In einer vorteilhaften Ausgestaltung der Erfindung ist die Auswerteinheit derart ausgestaltet, dass jeder Wertesatz eine feste Anzahl Wertepaare aufweist.

Dies hat den besonderen Vorteil, dass eine einfache Möglichkeit zur zyklischen Berechnung der Lichtbogenspannung gegeben ist, da in jedem Durchgang die gleiche Anzahl Wertepaare ausgewertet werden kann.

In einer vorteilhaften Ausgestaltung der Erfindung ist die Auswerteinheit derart ausgestaltet, dass fortwährend die Wertepaare einem Wertesatz zugeordnet werden, bis die feste Anzahl Wertepaare erreicht ist, und die nachfolgenden Wertepaare dem nächsten Wertesatz zugeordnet werden.

Dies hat den besonderen Vorteil, dass sowohl eine genauere als auch zyklische Ermittlung der Lichtbogenspannung ermöglicht wird.

In einer vorteilhaften Ausgestaltung der Erfindung ist die Auswerteinheit derart ausgestaltet, dass die elektrischen Spannungswerte oder/und Stromgrößen mit einem festen Zeitabstand (dt) ermittelt werden.

Dies hat wiederum den besonderen Vorteil, dass eine besonders genaue Ermittlung der Lichtbogenspannung bzw. eines Störlichtbogen ermöglicht wird.

In einer vorteilhaften Ausgestaltung der Erfindung ist die Auswerteeinheit derart ausgestaltet, dass für die Berechnung der Lichtbogenspannung ($U_{lb}$) aus einem Wertesatz mindestens einer der folgenden Terme gebildet wird:

a) ein Zeit-Spannungssummen-Produkt (us), gebildet aus dem Zeitabstand (dt) und der Summe der Spannungswerte (um), wobei die Summe der Spannungswerte durch den halben ersten Spannungswert, den halben letzten Spannungswert und der Summe der übrigen Spannungswerte des Wertesatzes gebildet wird;

b) ein Zeit-Stromsummen-Produkt (is), gebildet aus dem Zeitabstand (dt) und der Summe der Stromwerte, wobei die Summe des Stromwerte durch den halben ersten Stromwert, den halben letzten Stromwert und der Summe des übrigen Stromwerte des Wertesatzes gebildet wird;

c) ein Zeit-Stromänderungswert-Produkt (i's), gebildet aus dem Zeitabstand (dt) und der Summe der Werte für die Änderung des Stromes nach der Zeit, wobei die Summe der Werte für die Änderung des Stromes nach der Zeit durch den halben ersten Wert, den halben letzten Wert und der Summe der übrigen Werte des Wertesatzes gebildet wird;

d) ein Zeit-Vorzeichenwert-Produkt (ss), gebildet aus dem Zeitabstand (dt) und der Summe der Vorzeichenwerte der Stromwerte, wobei ein Vorzeichenwert den Wert plus Eins bei positiven Stromwert, minus Eins bei negativen Stromwert und Null bei einem Stromwert von Null annimmt, wobei die Summe der Vorzeichenwerte aus dem halben Vorzeichenwert des ersten Stromwertes, dem halben Vorzeichenwert des letzten Stromwertes und der Summe der Vorzeichenwerte der übrigen Stromwerte gebildet wird.

Dies hat den besonderen Vorteil, dass mit mindestens einem dieser Terme eine Ermittlung der Störlichtbogenspannung ermöglicht wird.

In einer vorteilhaften Ausgestaltung der Erfindung ist die Auswerteinheit derart ausgestaltet, dass ein Vorzeichenwert des Stromwertes den Wert Null annimmt, wenn der Betrag des Spannungswertes dieses Wertepaares einen zweiten Schwellwert unterschreitet. D.h. das Ergebnis der Vorzeichenfunktion bzw. Signumfunktion wird immer Null gesetzt, wenn der Betrag des zeitgleichen Spannungswerts kleiner-gleich dem zweiten Schwellwert ist. Als typischer Schwellwert kann hierfür z.B. ein Anoden-Kathodenspannungsfall von etwa 20 V angenommen werden, da davon ausgegangen werden kann, dass unter diesem zweiten Schwellwert kein Lichtbogen entstehen kann.

Durch Einführung dieser Nebenbedingung für die Berechnung der Signumfunktion werden bei der Lichtbogenzündung Instabilitäten in der Berechnung der Lichtbogenspannung wesentlich minimiert. Dies hat den besonderen Vorteil, dass insbesondere bei und nach der Lichtbogenzündung genauere Berechnungsergebnisse vorliegen und somit eine bessere Störlichtbogenerkennung ermöglicht wird.

In einer vorteilhaften Ausgestaltung der Erfindung ist die Auswerteeinheit derart ausgestaltet, dass für die Berechnung der Lichtbogenspannung ($U_{lb}$) für zwei aufeinanderfolgende Wertesätze jeweils die folgenden Terme gebildet werden:

ein erstes (us1) und ein zweites (us2) Zeit-Spannungssummen-Produkt,
ein erstes (is1) und ein zweites (is2) Zeit-Stromsummen-Produkt,
ein erstes (i's1) und ein zweites (i's2) Zeit-Stromänderungswert-Produkt,
ein erstes (ss1) und ein zweites (ss2) Zeit-Vorzeichenwert-Produkt berechnet wird.

Dies hat den besonderen Vorteil, dass eine einfache, insbesondere integrierende, Ermittlung der Störlichtbogenspannung ermöglicht wird.

In einer vorteilhaften Ausgestaltung der Erfindung ist die Auswerteeinheit derart ausgestaltet, dass für die Berechnung der Lichtbogenspannung ($U_{lb}$) für drei aufeinanderfolgende Wertesätze jeweils die folgenden Terme gebildet werden:

ein erstes (us1), ein zweites (us2) und ein drittes (us3) Zeit-Spannungssummen-Produkt,
ein erstes (is1), ein zweites (is2), und ein drittes (is3) Zeit-Stromsummen-Produkt,
ein erstes (i's1), ein zweites (i's2)und ein drittes (i's3) Zeit-Stromänderungswert-Produkt,
ein erstes (ss1), ein zweites (ss2) und ein drittes (ss3) Zeit-Vorzeichenwert-Produkt berechnet wird.

Dies hat den besonderen Vorteil, dass eine einfache und genauere, insbesondere integrierende, Ermittlung der Störlichtbogenspannung ermöglicht wird.

In einer vorteilhaften Ausgestaltung der Erfindung ist die Auswerteeinheit derart ausgestaltet, dass für die Berechnung der Lichtbogenspannung ($U_{lb}$) mindestens einer der folgenden Terme gebildet wird:

ein erstes Produkt (P1), gebildet aus dem dritten Zeit-Spannungssummen-Produkt (us3) und dem zweiten Zeit-Stromsummen-Produkt (is2),
ein zweites Produkt (P2), gebildet aus dem zweiten Zeit-Spannungssummen-Produkt (us2) und dem dritten Zeit-Stromsummen-Produkt (is3),
ein drittes Produkt (P3), gebildet aus dem zweiten Zeit-Stromänderungswert-Produkt (i's2) und dem ersten Zeit-Stromsummen-Produkt (is1),
ein viertes Produkt (P4), gebildet aus dem ersten Zeit-Stromänderungswert-Produkt (i's1) und dem zweiten Zeit-Stromsummen-Produkt (is2),
ein fünftes Produkt (P5), gebildet aus dem zweiten Zeit-Spannungssummen-Produkt (us2) und dem ersten Zeit-Stromsummen-Produkt (is1),
ein sechstes Produkt (P6), gebildet aus dem ersten Zeit-Spannungssummen-Produkt (us1) und dem zweiten Zeit-Stromsummen-Produkt (is2),
ein siebtes Produkt (P7), gebildet aus dem dritten Zeit-Stromänderungswert-Produkt (i's3) und dem zweiten Zeit-Stromsummen-Produkt (is2),
ein achtes Produkt (P8), gebildet aus dem zweiten Zeit-Stromänderungswert-Produkt (i's2) und dem dritten Zeit-Stromsummen-Produkt (is3),
ein neuntes Produkt (P9), gebildet aus dem ersten Zeit-Vorzeichenwert-Produkt (ss1) und dem zweiten Zeit-Stromsummen-Produkt (is2),
ein zehntes Produkt (P10), gebildet aus dem zweiten Zeit-Vorzeichenwert-Produkt (ss2) und dem ersten Zeit-Stromsummen-Produkt (is1),
ein elftes Produkt (P11), gebildet aus dem zweiten Zeit-Vorzeichenwert-Produkt (ss2) und dem dritten Zeit-Stromsummen-Produkt (is3),
ein zwölftes Produkt (P12), gebildet aus dem dritten Zeit-Vorzeichenwert-Produkt (ss3) und dem zweiten Zeit-Stromsummen-Produkt (is2),
eine erste Differenz (D1), dessen Minuend das erste Produkt (P1) und dessen Subtrahend das zweite Produkt (P2) ist,
eine zweite Differenz (D2), dessen Minuend das dritte Produkt (P3) und dessen Subtrahend das vierte Produkt (P4) ist,
eine dritte Differenz (D3), dessen Minuend das fünfte Produkt (P5) und dessen Subtrahend das sechste Produkt (P6) ist,

eine vierte Differenz (D4), dessen Minuend das siebte Produkt (P7) und dessen Subtrahend das achte Produkt (P8) ist

eine fünfte Differenz (D5), dessen Minuend das neunte Produkt (P9) und dessen Subtrahend das zehnte Produkt (P10) ist,

eine sechste Differenz (D6), dessen Minuend das elfte Produkt (P11) und dessen Subtrahend das zwölfte Produkt (P12) ist,

ein dreizehntes Produkt (P13), gebildet aus der ersten Differenz (D1) und der zweiten Differenz (D2),

ein vierzehntes Produkt (P14), gebildet aus der dritten Differenz (D3) und der vierten Differenz (D4),

ein fünfzehntes Produkt (P15), gebildet aus der fünften Differenz (D5) und der vierten Differenz (D4),

ein sechzehntes Produkt (P16), gebildet aus der sechsten Differenz (D6) und der zweiten Differenz (D2),

eine siebte Differenz (D7), dessen Minuend das dreizehnte Produkt (P13) und dessen Subtrahend das vierzehnte Produkt (P14) ist,

eine achte Differenz (D8), dessen Minuend das fünfzehnte Produkt (P15) und dessen Subtrahend das sechzehnte Produkt (P16) ist.

Dies hat den besonderen Vorteil, dass mit mindestens einem dieser Terme eine Ermittlung, insbesondere auf einem integrierenden Ansatz beruhende, der Störlichtbogenspannung ermöglicht wird.

In einer vorteilhaften Ausgestaltung der Erfindung ist die Auswerteeinheit derart ausgestaltet, dass die Lichtbogenspannung (Ulb) ein Quotient ist, dessen Dividend die siebte Differenz (D7) aufweist und dessen Divisor die achte Differenz (D8) aufweist.

Dies hat den besonderen Vorteil, dass eine sehr genaue Ermittlung einer Störlichtbogenspannung ermöglicht wird.

In einer vorteilhaften Ausgestaltung der Erfindung ist die Auswerteeinheit derart ausgestaltet, dass die Lichtbogenspannung (Ulb) auf den Wert Null gesetzt wird, wenn die Summe des ersten (ss1), zweiten (ss2) und dritten (ss3) Zeit-Vorzeichenwert-Produkts gleich Null ist.

Dies hat den besonderen Vorteil, dass unzulässige Berechnungsergebnisse bei der Berechnung der Lichtbogenspannung vermieden werden. Diese können Auftreten, wenn die drei Zeit-Vorzeichenwert-Produkte (ss1, ss2, ss3) jeweils Null sind. In diesem Fall wird die Lichtbogenspannung auf den Wert Null gesetzt.

Erfindungsgemäß ist ferner ein Leistungsschalter für einen elektrischen Niederspannungsstromkreis vorgesehen. Dieser weist eine erfindungsgemäße Störlichtbogenerkennungseinheit auf. Diese ist mit dem Leistungsschalter verbunden, wobei diese derart ausgestaltet sind, dass bei Abgabe eines Störlichtbogenerkennungssignals der Leistungsschalter auslöst, d.h. den elektrischen Stromkreis unterbricht. Somit kann eine Löschung des Störlichtbogens erreicht werden. Weist der Leistungsschalter eine elektronische Auslöseeinheit auf, kann eine sehr schnelle Auslösung des Leistungsschalters bei Vorliegen eines Störlichtbogenerkennungssignals erreicht werden. Dies hat den besonderen Vorteil, dass ein Leistungsschalter um eine weitere, vorteilhafte Funktionalität zum Schutz elektrischer Anlagen erweitert wird. Die Erkennung und Abschaltung von Störlichtbögen erfolgt dabei vorteilhaft in einem Gerät. Gegebenenfalls lassen sich vorhandene Baugruppen, wie Spannungs- oder/und Stromsensoren, Netzteil, Mikroprozessoren für die Auswerteeinheit, etc. mitverwenden und so Synergien erzielen.

Erfindungsgemäß ist ferner ein Kurzschließer, aufweisend eine Störlichtbogenerkennungseinheit die mit dem Kurzschließer verbunden ist, vorgesehen. Diese sind derart ausgestaltet, dass bei Abgabe eines Störlichtbogenerkennungssignals der Kurzschließer den elektrischen Stromkreis kurzschließt, um ein Löschen des Störlichtbogens zu bewirken.

Dies hat den besonderen Vorteil, dass eine einfache, schnelle und wirksame Möglichkeit zum Löschen von Störlichtbögen zur Verfügung steht.

Erfindungsgemäß ist des Weiteren ein Verfahren zur Störlichtbogenerkennung für einen elektrischen Stromkreis, insbesondere Niederspannungsstromkreis, vorgesehen. Hierbei werden periodisch elektrische Spannungswerte und Stromgrößen des Stromkreises ermittelt, so dass fortlaufend Wertepaare, aufweisend einen Spannungswert und eine Stromgröße, vorliegen. Ein Wertesatz umfasst mehrere Wertepaare. Aus (mindestens) zwei Wertesätzen wird eine Lichtbogenspannung berechnet, die mit einem ersten Schwellwert verglichen wird und bei dessen Überschreitung wird ein Störlichtbogenerkennungssignal abgegeben.

Dies hat den Vorteil, dass ein einfaches Verfahren zur Erkennung eines Störlichtbogens gegeben ist.

Alle Ausgestaltungen und Merkmale, sowohl einzeln auch als im gemeinsamen zusammenwirken, der Erfindung bewirken eine Verbesserung der Erkennung von Störlichtbögen bzw. deren Löschung.

Die beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Hierbei zeigt:

Figur 1 ein Diagramm des zeitlichen Spannungs- und Stromverlaufes nach Lichtbogenzündung

Figur 2 ein Ersatzschaltbild eines elektrischen Stromkreises

Figur 3 ein Ablaufdiagramm zur Störlichtbogenerkennung

Figur 4 ein Blockschaltbild einer erfindungsgemäßen Lösung

Figur 5 eine erste Darstellung zur Erläuterung des Einsatzes der Erfindung

Figur 6 eine zweite Darstellung zur Erläuterung des Einsatzes der Erfindung

Figur 7 eine dritte Darstellung zur Erläuterung des Einsatzes der Erfindung

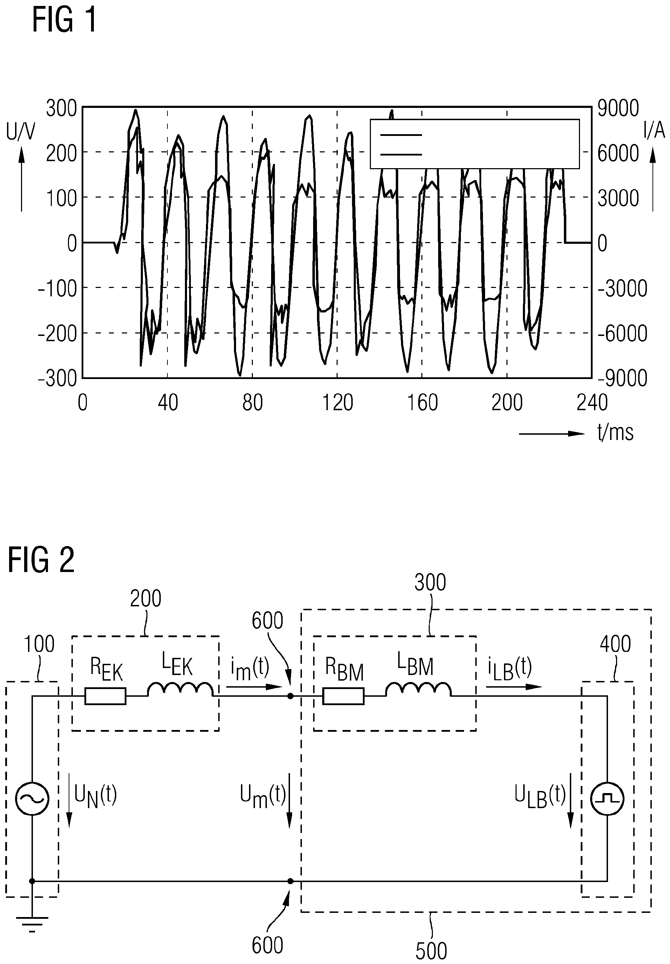

In einem Stromkreis bzw. Netz, in dem ein Störlichtbogen brennt, kann ein Strom- und Spannungsverlauf gemessen werden, der einen signifikanten Verlauf aufweist. Ein typischer Spannungs- und Stromverlauf für einen Störlichtbogen ist in Figur 1 dargestellt. Diese zeigt eine Darstellung eines Diagramms, in dem der zeitliche Verlauf der elektrischen Spannung U und des elektrischen Stromes I nach Zündung eines Lichtbogens bzw. Störlichtbogens, insbesondere parallelen Störlichtbogen, in einem elektrischen Stromkreis, insbesondere Niederspannungsstromkreis, dargestellt ist.

Auf der horizontalen X-Achse ist die Zeit t in Millisekunden (ms) dargestellt. Auf der vertikalen Y-Achse ist auf der linken Skalierung die Größe der elektrischen Spannung U in Volt (V) abgebildet. Auf der rechten Skalierung ist die Größe des elektrischen Stromes I in Ampere (A) abgebildet.

Fortlaufend bzw. periodisch werden elektrische Spannungswerte $u_m$ und elektrische Stromwerte $i_m$ ermittelt, beispielsweise mit je einem Sensor. Dabei kann beispielsweise der elektrische Strom $i_m$ direkt gemessen werden. Alternativ kann auch die Änderung des Stromes nach der Zeit $i'_m$ gemessen werden. Im Falle der Messung des elektri-schen Stromes $i_m$ kann daraus die Änderung des Stromes nach der Zeit $i'_m$ ermittelt werden, beispielsweise durch Differentiation des Stromwertes im.

Im Falle der Messung der Änderung des elektrischen Stromes nach der Zeit $i'_m$ kann daraus der elektrische Strom $i_m$ ermittelt werden, beispielsweise durch Integration der Änderung des elektrischen Stromes nach der Zeit $i'_m$. Die Messung der Änderung des elektrischen Stromes nach der Zeit $i'_m$ kann beispielsweise mit einer Rogowskispule erfolgen. Im Falle sinusförmiger Ströme im Stromkreis ist die Integration besonders einfach zu realisieren, da das Intergral vom Sinus ein Cosinus und vom Cosinus ein Sinus ist.

Ebenso kann der Stromwert $i_m$ und die Änderung des Stromes nach der Zeit $i'_m$ auch parallel, z.B. mit 2 Sensoren, gemessen werden. Damit erübrigt sich eine Umrechnung.

Mit einem zeitlichen Abstand, beispielsweise einem festen zeitlichen Abstand dt, werden immer wieder Span-nungswerte $u_m$ und Stromwerte $i_m$ bzw. Spannungswerte $u_m$ und Werte für die Änderung des elektrischen Stromes nach der Zeit $i'_m$ ermittelt. Die Ermittlung kann dabei durch Abtastung der Werte erfolgen. Dabei sollte die Abtastfrequenz bzw. Meßfrequenz ein vielfaches der Frequenz der gemessenen Wechselgrößen betragen. Beispielsweise könnte bei üblichen Stromnetzen, mit beispielsweise 50Hz bzw. 60Hz, die Meßfrequenz im Kilohertz-Bereich liegen, beispielsweise zwischen 1 und 200 kHz, spezifischer bei 10 bis 60 oder 100 kHz, insbesondere im Bereich 40-50 kHz.

Dabei werden beispielsweise ein Spannungswert und eine Stromgröße jeweils zu einem, insbesondere gleichen, Zeitpunkt ermittelt. Bezüglich der Stromgröße können auch parallel zwei Werte der Stromgröße, wie Stromwert und Änderung des Stromwertes nach der Zeit, ermittelt werden.

Figur 2 zeigt ein Ersatzschaltbild eines elektrischen Stromkreises, aufweisend ein elektrische Energiequelle 100, die eine elektrische Netz-Spannung $u_n(t)$ zur Verfügung stellt, ein daran angeschlossenen Netzzugang bzw. ein Einspeise-Kabel 200, dargestellt durch elektrische Ersatzschaltelemente, wie einen Einspeise-Kabel-Widerstand $R_{ek}$ und eine Einspeise-Kabel-Induktivität bzw. Spule $L_{ek}$, dem ein elektrischer Verbraucher, Betriebsmittel bzw. Energiesenke 300 folgt, wiederum dargestellt durch elektrische Ersatzschaltelemente, wie einen Verbraucher-Widerstand $R_{BM}$ und eine Verbraucher-Induktivität bzw. Spule $L_{BM}$. Zwischen Einspeise-Kabel 200 und Verbraucher 300 kann eine elektrische Spannung $u_m(t)$ und eine elektrische Stromgröße, wie der elektrische Stromwert $i_m(t)$ oder/und die Änderung des Stromes nach der Zeit $i'_m(t)$, respektive die erste Ableitung des Stromes nach der Zeit, gemessen werden. Diese Größen werden an den Meßpunkten 600 erfasst, um in der Störlichtbogenerkennungseinheit weiter verarbeitet zu werden.

Der hinsichtlich Störlichtbogen überwachte Bereich ist durch eine gestrichelte Linie 500 dargestellt.

Im elektrischen Stromkreis kann ein Störlichtbogen auftreten, der durch einen Lichtbogen 400 mit einer Lichtbogenspannung $U_{lb}(t)$ dargestellt ist. Erfindungsgemäß wird fortlaufend eine Lichtbogenspannung $U_{lb}$ in der Störlichtbogenerkennungseinheit mit Hilfe der gemessenen/abgetasteten Spannung $u_m(t)$ und der gemessenen/abgetasteten Stromgröße (Strom oder/und Stromänderung) berechnet.

Erfindungsgemäß wird für die Berechnung die Spannung, der Strom und die Änderung des Stromes nach der Zeit verwendet. Hierzu wird ein solches Wertepaar mindestens einem Wertesatz zugeordnet. In einer bevorzugten Ausführungsform wird ein Wertepaar genau einem Wertesatz zugeordnet. Wesentlich ist, dass ein Wertesatz mindestens ein Wertepaar enthält, das nicht im vorhergehenden oder nachfolgenden Wertesatz enthalten ist. Erfindungsgemäß wird aus mindestens zwei Wertesätzen eine Lichtbogenspannung berechnet.

In einer bevorzugten Ausgestaltung wird eine feste Anzahl Wertepaare, die beispielsweise zeitlich nacheinander, beispielsweise mit festem zeitlichem Abstand, ermittelt werden, einem Wertesatz zugeordnet. Beispielsweise enthält ein Wertesatz 10 Wertepaare. Die ersten 10 Wertepaare werden dem ersten Wertesatz zugeordnet. Die zweiten 10 Wertepaare werden dem zweiten Wertesatz zugeordnet, die dritten 10 Wertepaare dem dritten Wertesatz usw. Jeweils mindestens 2 Wertesätze werden für die Ermittlung einer Lichtbogenspannung bzw. eines Störlichtbogens verwendet. Die Berechnung erfolgt fortlaufend, d.h. beispielsweise erste Berechnung mit den Wertesätzen 1 und 2 bzw. 1 bis 3, zweite erfindungsgemäße Berechnung mit den Wertesätzen 2 und 3 bzw. 2 bis 4, usw. (erste Angabe für Berechnung mit 2 Wertesätzen, zweite Angabe für Berechnung mit 3 Wertesätzen).

1.Beispiel:

Beispielsweise werden Wertepaare von 1 bis x (x $\geq$ 32; $x \in \mathbb{N}$) abgetastet und ein Wertesatz besteht aus 10 Wertepaaren. Jeweils 3 Wertesätze werden für die Ermittlung einer Lichtbogenspannung bzw. eines Störlichtbogens verwendet.

Die Wertepaare 1 - 10 werden dem Wertesatz 1 zugeordnet.
Die Wertepaare 11 - 20 werden dem Wertesatz 2 zugeordnet.
Die Wertepaare 21 - 30 werden dem Wertesatz 3 zugeordnet.

Die Berechnung erfolgt fortlaufend, d.h. beispielsweise erste erfindungsgemäße Berechnung mit den Wertepaaren 1 bis 30, zweite erfindungsgemäße Berechnung mit den Wertepaaren 2 bis 31, dritte erfindungsgemäße Berechnung mit den Wertepaaren 3 bis 32, usw. Somit steht zu jedem Abtastpunkt ein Berechnungsergebnis für die anschließende Auswertung zur Verfügung.

2.Beispiel:

Für die Berechnung können sich auch Wertesätze überlagern. D.h. zwei Wertesätze können ein oder mehrere gleiche Wertepaare verwenden. Wobei hier der Grundsatz gilt, dass in jedem Wertesatz mindestens ein weiteres Wertepaar vorhanden sein muss, dass in den anderen Wertessätzen nicht verwendet wird. Beispielsweise es werden Wertepaare von 1 bis $x$ (x $\geq$ 14; $x \in \mathbb{N}$) abgetastet und ein Wertesatz besteht aus 10 Wertepaaren. Jeweils 3 Wertesätze werden für die Ermittlung einer Lichtbogenspannung bzw. eines Störlichtbogens verwendet.

Die Wertepaare 1 - 10 werden dem Wertesatz 1 zugeordnet.
Die Wertepaare 2 - 11 werden dem Wertesatz 2 zugeordnet.
Die Wertepaare 3 - 12 werden dem Wertesatz 3 zugeordnet.

Die Berechnung erfolgt fortlaufend, d.h. beispielsweise erste erfindungsgemäße Berechnung mit den Wertepaaren 1 bis 12, zweite erfindungsgemäße Berechnung mit den Wertepaaren 2 bis 13, dritte erfindungsgemäße Berechnung mit den Wertepaaren 3 bis 14, usw. Somit steht zu jedem Abtastpunkt ein Berechnungsergebnis für die anschließende Auswertung zur Verfügung.

3.Beispiel:

Für die Berechnung können die Wertesätze auch eine unterschiedliche Größe besitzen. Beispielsweise werden Wertepaare von 1 bis $x$ (x $\geq$ 17; $x \in \mathbb{N}$) abgetastet. Jeweils 3 Wertesätze werden für die Ermittlung einer Lichtbogenspannung bzw. eines Störlichtbogens verwendet, wobei der 1. Wertesatz aus 6 Wertepaaren besteht, der 2. Wertesatz aus 15 Wertepaaren besteht und der 3. Wertesatz aus 9 Wertepaaren besteht.

Die Wertepaare 1 - 6 werden dem Wertesatz 1 zugeordnet.
Die Wertepaare 1 - 15 werden dem Wertesatz 2 zugeordnet.
Die Wertepaare 6 - 15 werden dem Wertesatz 3 zugeordnet.

Die Berechnung erfolgt fortlaufend, d.h. beispielsweise erste erfindungsgemäße Berechnung mit den Wertepaaren 1 bis 15; darin sind die drei Wertesätze enthalten. Die zweite erfindungsgemäße Berechnung mit den Wertepaaren 2 bis 16 und dritte erfindungsgemäße Berechnung mit den Wertepaaren 3 bis 17, usw. Somit steht zu jedem Abtastpunkt ein Berechnungsergebnis für die anschließende Auswertung zur Verfügung.

Im Weiteren können beispielsweise die Wertepaare auch nacheinander angeordnet sein und einen Abstand von einer bestimmten Anzahl von Wertepaaren zueinander haben.

Die Berechnung erfolgt dadurch, dass fortlaufend gewisse Terme (mathematische Ausdrücke bzw. Gleichungen) berechnet werden.

Die Berechnung dieser Terme basiert auf einer Lösung der Leitungsgleichung 1.Ordnung:

$$u_m(t) = R_{BM} \cdot i_m(t) + L_{BM} \frac{di_m(t)}{dt} \qquad (1)$$

Unter der Annahme, dass im Niederspannungsnetz ein Störlichtbogen vorhanden ist, so wäre das elektrische Verhalten vergleichbar mit dem einer Gegenspannungsquelle im Netz.
Daraus ergibt sich die folgende, erweiterte Ansatzdifferenzialgleichung:

$$u_m(t) = R_{BM} \cdot i_m(t) + L_{BM} \frac{di_m(t)}{dt} + u_{LB}(t) \qquad (2)$$

Der Störlichtbogen wird vereinfacht als rein ohmscher Verbraucher nachgebildet. Somit wird angenommen, dass die Lichtbogenspannung phasengleich zum Lichtbogenstrom ist. Die Lichtbogenspannung kann somit mit folgender Gleichung beschrieben werden:

$$u_{LB}(t) = U_{LB} \cdot \text{sign}\big(i_{LB}(t)\big) \qquad (3)$$

Wird davon ausgegangen, dass der Messstrom $i_m(t)$ dem Störlichtbogenstrom $\mathbf{i_{LB}(t)}$ entspricht, also keine Stromverzweigung zwischen Messort und Störlichtbogenbrennstelle vorhanden ist, kann geschrieben werden:

$$u_m(t) = R_{BM} \cdot i_m(t) + L_{BM} \frac{di_m(t)}{dt} + \text{sign}\big(i_m(t)\big) \cdot U_{LB} \qquad (4)$$

Zum Lösen dieser erweiterten Ansatzdifferenzialgleichung wird erfindungsgemäß ein integrierendes Lösungsverfahren verwendet. Somit ergibt sich ein vollständiger, integrierender Ansatz:

$$\int u_m(t)\, dt = R_{BM} \int i_m(t)\, dt + L_{BM} \int \frac{di_m(t)}{dt}\, dt + U_{LB} \int \text{sign}\big(i_m(t)\big)\, dt \qquad (5)$$

Die Berechnung der Lichtbogenspannung erfolgt durch Umstellen und Auflösen der Gleichung (5) nach $\mathbf{U_{LB}}$.

Für die Berechnung wird die folgende Ansatzgleichung verwendet:

$$\begin{aligned} \int u_m(t)\, dt &= R_{BM} \int i_m(t)\, dt + L_{BM} \int \frac{di_m(t)}{dt}\, dt + U_{LB} \int \text{sign}\big(i_m(t)\big)\, dt \\ &= R_{BM} \int i_m(t)\, dt + L_{BM} \int i'_m(t)\, dt + U_{LB} \int \text{sign}\big(i_m(t)\big)\, dt \end{aligned} \qquad (6)$$

Für die nummerische Integration wird beispielsweise das Sehnentrapezverfahren nach Gleichung (7) verwendet.

$$\int_{t_A}^{t_E} f(t)dt \approx \frac{\Delta t}{2}\left[ f(t_A) + 2 \sum_{\nu=1}^{\frac{t_E-t_A}{\Delta t}-1} f(t_A + \nu \cdot \Delta t) + f(t_E) \right] \qquad (7)$$

Für eine vereinfachte Darstellung der Lösung werden die mit der Sehnentrapezregel gelösten Integrationsintervalle durch folgende Terme substituiert:

$$u_s = \frac{\Delta t}{2}\left[ u_m(t_A) + 2 \sum_{\nu=1}^{\frac{t_E-t_A}{\Delta t}-1} u_m(t_A + \nu \cdot \Delta t) + u_m(t_E) \right] \qquad (8)$$

$$i_s = \frac{\Delta t}{2}\left[ i_m(t_A) + 2 \sum_{\nu=1}^{\frac{t_E-t_A}{\Delta t}-1} i_m(t_A + \nu \cdot \Delta t) + i_m(t_E) \right] \qquad (9)$$

$$i'_s = \frac{\Delta t}{2}\left[ i'_m(t_A) + 2 \sum_{\nu=1}^{\frac{t_E-t_A}{\Delta t}-1} i'_m(t_A + \nu \cdot \Delta t) + i'_m(t_E) \right] \qquad (10)$$

$$s_s = \frac{\Delta t}{2}\left[ \text{sign}(i_m(t_A)) + 2 \sum_{\nu=1}^{\frac{t_E-t_A}{\Delta t}-1} \text{sign}(i_m(t_A + \nu \cdot \Delta t)) + \text{sign}(i_m(t_E)) \right] \qquad (11)$$

$$t_s = \frac{t_E - t_A}{\Delta t}$$

Der Wert $t_s$ ist dabei die Anzahl der Wertepaare pro Wertesatz, $\Delta t$ entspricht dem Bezugszeichen dt, welches dem zeitlichen Abstand der abgetasteten Spannungswerte bzw. Stromgrößen respektive Wertepaare entspricht. Die Variable $t_E$ entspricht der Zeit vom zeitlich letzten Wertepaar eines Wertesatzes, $t_A$ entspricht der Zeit vom zeitlich ersten Wertepaar des Wertesatzes.

Mit den Formel 8 bis 11 werden für einen Wertesatz jeweils die folgenden Terme berechnet:

(8) ein Zeit-Spannungssummen-Produkt ($u_S$), gebildet aus dem Zeitabstand (dt) und der Summe der Spannungswerte ($u_m$), wobei die Summe der Spannungswerte durch den halben ersten Spannungswert, den halben letzten Spannungswert und der Summe der übrigen Spannungswerte des Wertesatzes gebildet wird.

(9) ein Zeit-Stromsummen-Produkt ($i_S$), gebildet aus dem Zeitabstand (dt) und der Summe der Stromwerte, wobei die Summe des Stromwerte durch den halben ersten Stromwert, den halben letzten Stromwert und der Summe des übrigen Stromwerte des Wertesatzes gebildet wird.

(10) ein Zeit-Stromänderungswert-Produkt ($i'_S$), gebildet aus dem Zeitabstand (dt) und der Summe der Werte für die Änderung des Stromes nach der Zeit, wobei die Summe der Werte für die Änderung des Stromes nach der Zeit durch den halben ersten Wert, den halben letzten Wert und der Summe der übrigen Werte des Wertesatzes gebildet wird.

(11) ein Zeit-Vorzeichenwert-Produkt ($s_S$), gebildet aus dem Zeitabstand (dt) und der Summe der Vorzeichenwerte der Stromwerte, wobei ein Vorzeichenwert den Wert plus Eins bei positiven Stromwert, minus Eins bei negativen Stromwert und Null bei einem Stromwert von Null annimmt, wobei die Summe der Vorzeichenwerte aus dem halben Vorzeichenwert des ersten Stromwertes, dem halben Vorzeichenwert des letzten Stromwertes und der Summe der Vorzeichenwerte der übrigen Stromwerte gebildet wird.

Mit den substituierten Termen ergibt sich das Gleichungssystem entsprechend der Ansatzgleichung 5 zu:

$$u_s = R_{BM}i_s + L_{BM}i'_s + U_{LB}s_s \qquad (13)$$

Das Gleichungssystem enthält die drei unbekannten len **R_BM**, **L_BM** und **U_LB**. Für die Lösung dessen werden (mindestens) zwei, für eine sehr genaue Ermittlung drei, voneinander zeitlich unterschiedliche Integrationsgrenzen verwendet, beispielsweise durch erfindungsgemäße Verwendung zweier bzw. dreier Wertesätze.

$$u_{s1} = R_{BM}i_{s1} + L_{BM}i'_{s1} + U_{LB}s_{s1}$$
$$u_{s2} = R_{BM}i_{s2} + L_{BM}i'_{s2} + U_{LB}s_{s2} \qquad (14)$$
$$u_{s3} = R_{BM}i_{s3} + L_{BM}i'_{s3} + U_{LB}s_{s3}$$

Die Lichtbogenspannung **U_LB** lässt sich folglich erfindungsgemäß beispielsweise mit der folgenden Formel berechnen.

$$U_{LB} = \frac{(u_{s3}i_{s2} - u_{s2}i_{s3})(i'_{s2}i_{s1} - i'_{s1}i_{s2}) - (u_{s2}i_{s1} - u_{s1}i_{s2})(i'_{s3}i_{s2} - i'_{s2}i_{s3})}{(s_{s1}i_{s2} - s_{s2}i_{s1})(i'_{s3}i_{s2} - i'_{s2}i_{s3}) - (s_{s2}i_{s3} - s_{s3}i_{s2})(i'_{s2}i_{s1} - i'_{s1}i_{s2})} \qquad (15)$$

Wobei $u_s$, $i_s$, $i'_s$, $s_s$ die Zeit-Spannungssummen-Produkte, Zeit-Stromsummen-Produkte, Zeit-Stromänderungswert-Produkte, Zeit-Vorzeichenwert-Produkte, gemäß Formel 8 bis 11, eines ersten, zweiten und dritten Wertesatzes sind, gemäß Index.

Das Kürzel sign bzw. sgn steht für die Signumfunktion respektive Vorzeichenfunktion. Diese Funktion ordnet einer Zahl ihr Vorzeichen zu. Diese ist wie folgt definiert:

sign(x) = +1, falls x>0;
sign(x) = 0, falls x=0;
sign(x) = -1, falls x<0.

Die Formel 14 besteht aus 12 Produkten P1,...,P12, die enthalten:

a) Produkte aus Zeit-Spannungssummen-Produkten $u_s$ und Zeit-Stromsummen-Produkten $i_s$,
b) Produkte aus Zeit-Stromdummen-Produkten $i_s$ und Zeit-Stromänderungswert-Produkten $i'_s$,
c) Produkte aus Zeit-Vorzeichenwert-Produkten $s_s$ und Zeit-Stromsummen-Produkte $i_s$.

$$U_{LB} = \frac{(P1 - P2)(P3 - P4) - (P5 - P6)(P7 - P8)}{(P9 - P10)(P7 - P8) - (P11 - P12)(P3 - P4)} \qquad (15)$$

$$U_{LB} = \frac{D1 * D2 - D3 * D4}{D5 * D4 - D6 * D2} \qquad (16)$$

$$U_{LB} = \frac{P13 - P14}{P15 - P16} \qquad (17)$$

$$U_{LB} = \frac{D7}{D8} \qquad (18)$$

Die 12 Produkte bilden 6 verschiedene Differenzen D1, ..., D6.
Die 6 Differenzen D1, ..., D6 bilden wiederum 4 übergeordnete Produkte P13, ..., P16. Diese bilden wiederum 2 übergeordnete Differenzen D7, D8, mit Hilfe denen eine Lichtbogenspannung ermittelt werden kann. Überschreitet diese einen ersten Schwellwert SW1, wird ein Störlichtbogenerkennungssignal SLES abgegeben.

Die Lichtbogenspannung lässt sich ferner beispielsweise mit den folgenden, vereinfachten Formeln, die ebenfalls Lösungen der Integralgleichung sind, berechnen. Hierbei werden erfindungsgemäß nur zwei Wertesätze für die Ermittlung benötigt.

$$U_{\mathrm{LB}} = \frac{u_{s2}i_{s1} - u_{s1}i_{s2}}{t_{s2}i_{s1} - t_{s1}i_{s2}} = \frac{P5 - P6}{P17 - P18} = \frac{D3}{D9}$$

$$U_{\mathrm{LB}} = \frac{u_{s2}i_{s1} - u_{s1}i_{s2}}{s_{s2}i_{s1} - s_{s1}i_{s2}} = \frac{P5 - P6}{P10 - P9} = \frac{D3}{D10}$$

$$U_{\mathrm{LB}} = \frac{u_{s2}i'_{s1} - u_{s1}i'_{s2}}{t_{s2}i'_{s1} - t_{s1}i'_{s2}} = \frac{P19 - P20}{P21 - P22} = \frac{D11}{D12}$$

$$U_{\mathrm{LB}} = \frac{u_{s2}i'_{s1} - u_{s1}i'_{s2}}{s_{s2}i'_{s1} - s_{s1}i'_{s2}} = \frac{P19 - P20}{P23 - P24} = \frac{D11}{D13}$$

Eine weitere beispielhafte Berechnung unter Verwendung dreier Wertesätze ist in der nachfolgenden Formel gegeben.

$$U_{\mathrm{LB}} = \frac{(u_{s2}i_{s1} - u_{s1}i_{s2})(i'_{s3}i_{s1} - i'_{s1}i_{s3}) - (u_{s3}i_{s1} - u_{s1}i_{s3})(i'_{s2}i_{s1} - i'_{s1}i_{s2})}{(t_{s1}i_{s3} - t_{s3}i_{s1})(i'_{s2}i_{s1} - i'_{s1}i_{s2}) - (t_{s1}i_{s2} - t_{s2}i_{s1})(i'_{s3}i_{s1} - i'_{s1}i_{s3})}$$

$$U_{\mathrm{LB}} = \frac{(P5 - P6)(P25 - P26) - (P27 - P28)(P3 - P4)}{(P29 - P30)(P3 - P4) - (P18 - P17)(P25 - P26)}$$

$$U_{\mathrm{LB}} = \frac{D3\,D14 - D15\,D2}{D16\,D2 - D17\,D14}$$

$$U_{\mathrm{LB}} = \frac{P31 - P32}{P33 - P34}$$

$$U_{\mathrm{LB}} = \frac{D18}{D19}$$

Jede Lösung der Integralgleichung, auch eine vereinfachte, stellt eine erfindungsgemäße Verwendung der Erfindung dar.

Für eine sichere Detektion eines Störlichtbogens ist es notwendig den Betriebsfall - Anlage ohne Störlichtbogen - vom Fehlerfall - Anlage mit Störlichtbogen - abzugrenzen. Mit der vorliegenden Erfindung wird die Störlichtbogenspannung für jeden Abtastwert neu berechnet. Mit einem darauf folgenden Schwellwertvergleich der ermittelten Lichtbogenspannung wird die Unterscheidung zwischen den Zuständen: a) Störlichtbogen vorhanden und b) Kein Störlichtbogen vorhanden, getroffen.

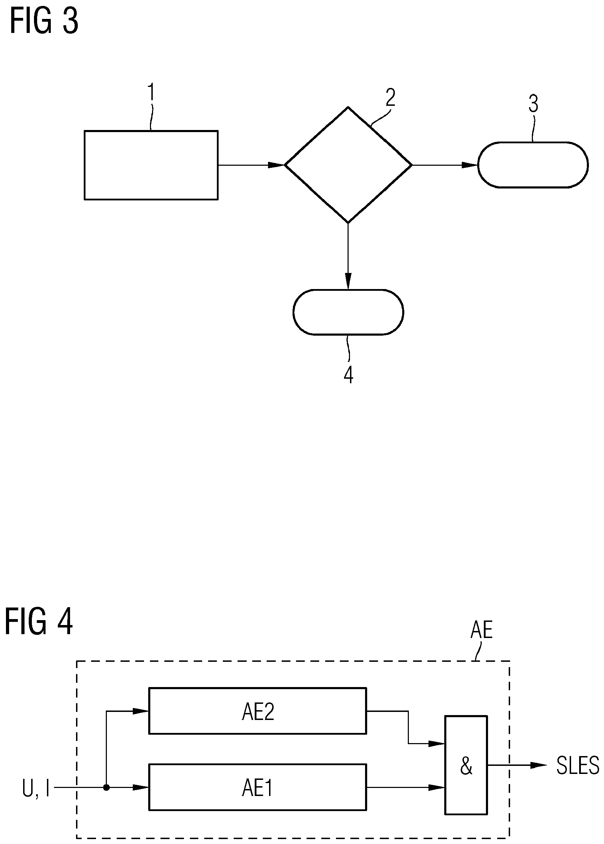

In Figur 3 ist ein derartiges Diagramm dargestellt. In einem ersten Schritt 1 erfolgt die fortlaufende Berechnung der Lichtbogenspannung.

In einem zweiten Schritt 2 wird diese bzw. dessen Betrag jeweils mit dem ersten Schwellwert SW1 verglichen.

Erfolgt eine Überschreitung des ersten Schwellwertes SW1, wird in einem dritten Schritt 3 die Erkennung eines Störlichtbogens angezeigt und/oder ein Störlichtbogenerkennungssignals abgegeben.

Ist der erste Schwellwert SW1 nicht überschritten, kann in einem vierten Schritt 4 die Meldung, dass kein Störlichtbogen vorhanden ist, erfolgen.

Beispielsweise kann der erste Schwellwert SW1 bei 30 Volt liegen.
Allgemein gesagt kann der Schwellwert für ein Niederspannungsnetz im Bereich 20 bis 300 Volt liegen, konkreter im Bereich 20 bis 150 Volt, spezifischer im Bereich 20 bis 70 Volt. Insbesondere Werte von 25 bis 50 Volt scheinen gut geeignet zu sein.

Bei der Berechnung der Lichtbogenspannung mit der erfindungsgemäßen Auswertung können bei der Zündung eines Lichtbogens starke Änderungen auftreten. Für eine schnelle und stabile Berechnung der Lichtbogenspannung können deshalb noch Verbesserungen derart erfolgen, dass beispielsweise die Vorzeichen- bzw. Signumfunktion modifiziert wird.

Im Allgemeinen berechnet sich die Signumfunktion aus dem gemessenen Strom wie folgt:

$$s(t) = \text{sign}\big(i_m(t)\big)$$

Stabile Berechnungsergebnisse liegen häufig erst für die Zeit nach der Lichtbogenzündung vor, wenn die Messspannung den brennenden Lichtbogen komplett erfasst hat und in den zwei bzw. drei Integrationsintervalle bzw. Wertesätze komplett enthalten ist. Im Übergangsbereich kann es zu instabilen Berechnungsergebnissen kommen. Werden für diesen Bereich die Berechnungsergebnisse gefiltert, so erfolgt dadurch eine geringfügige Verzögerung der Detektion, allerdings mit sichereren Ermittlungsergebnissen. Erfindungsgemäß kann daher eine weitere Ausgestaltung verwendet werden, bei der die Signumfunktion auf den Wert Null gesetzt wird, wenn die ermittelte Spannung einen zweiten Schwellwert SW2, wie z.B. einen Spannungsschwellwert, unterschreitet.

$$s(t) = 0 \mid |u_m(t)| \le U^S_{I-RLs}$$

Das Ergebnis der Signumfunktion wird z.B. immer Null gesetzt, wenn der Betrag des, beispielsweise zeitgleichen, Spannungswerts des Wertepaares kleiner-gleich dem zweiten Schwellwert SW2, wie $U^S_{I-RLs}$ , ist. Als typischer Schwellwert kann hierfür z.B. der Anoden-Kathodenspannungsabfall von etwa 20 V angenommen werden, da davon auszugehen ist, dass unter diesem Wert kein Lichtbogen entstehen kann. Der zweite Schwellwert SW2 bzw. $U^S_{I-RLs}$ kann jeden Wert im Bereich 5 bis 150 Volt, spezifischer im Bereich 10 Volt bis 50 Volt, insbesondere 15 bis 20 Volt annehmen.

Durch Einführung dieser Nebenbedingung für die Berechnung der Signumfunktion werden bei der Lichtbogenzündung eventuell auftretende Instabilitäten in der Berechnung der Lichtbogenspannung minimiert.

Der Ablauf ergibt sich analog zur Figur 3 dahingehend, dass im Schritt 1 die ermittelten Spannungswerte vorliegen. Im Schritt 2 ein Schwellwertvergleich mit dem zweiten Schwellwert durchgeführt wird. Bei Unterschreiten des Schwellwertes die Signum-Funktion für den zeitgleichen bzw. zeitlich entsprechenden Stromwert auf den Wert Null gesetzt wird. Dieser Wert dann für die weitere Berechnung verwendet wird.
Bei Überschreiten des Schwellwertes wie üblich die Signumfunktion bezogen auf den Stromwert angewendet wird.

Um weiterhin unzulässige Berechnungsergebnisse zu vermeiden, kann erfindungsgemäß vorteilhaft die Lichtbogenspannung auf den Wert Null gesetzt werden, wenn die Summe der zwei bzw. drei Integrale $s_s$ der Signumfunktion bzw. die Summe der zwei bzw. drei Zeit-Vorzeichenwert-Produkte $s_s$ den Wert Null ergibt.

$$U_{LB} = 0 \text{ V} \mid s_{s1} + s_{s2} = 0$$

$$U_{LB} = 0 \text{ V} \mid s_{s1} + s_{s2} + s_{s3} = 0$$

Die erfindungsgemäße Störlichtbogenerkennung kann mit weiteren Kriterien kombiniert werden. Beispielsweise mit einem weiteren Vergleich der Höhe des elektrischen Stromes des Stromkreises. Der gemessene Strom, insbesondere der Effektivwert des gemessenen Stromes, der beispielsweise nach der Methode von Mann-Morrison berechnet werden kann, wird dabei mit einem dritten Schwellwert SW3 verglichen und nur wenn dieser dritte Schwellwert SW3 überschritten ist und die berechnete Lichtbogenspannung den ersten Schwellwert SW1 überschreitet, wird ein Störlichtbogenerkennungssignal abgegeben.
Diese als Überstromfreigabe bezeichnetes Kriterium führt zu einer sicheren Fehlerabgrenzung. Für die Störlichtbogenerkennung muss ein minimaler Störlichtbogenstrom im Stromkreis fließen, um ein Störlichtbogenerkennungssignal zu bewirken. Als Schwellwert für die Überstromfreigabe kann ein vom Betriebsstrom abhängiger Wert gewählt werden. Alternativ könnte die Schwellwertfestlegung auch lichtbogenspezifisch erfolgen, da für einen brennenden parallelen Niederspannungslichtbogen ein Lichtbogenstrom von üblicherweise 1000 A notwendig ist. Bei seriellen Lichtbögen liegen deutlich geringere Ströme vor. D.h. der dritte Schwellwert SW3 kann je nach Einsatz bzw. Anwendung jeden Wert ab beispielsweise 1 A, 10 A, 100 A, 1000 A oder 5000 A annehmen.

Die Verknüpfung zwischen Überstromfreigabe und der erfindungsgemäßen Lichtbogenspannungsberechnung ist in Figur 4 dargestellt.

Figur 4 zeigt eine Darstellung, bei der die ermittelte Spannung U und die ermittelte Stromgröße des Stromkreises einer ersten Auswerteeinheit AE1, zur erfindungsgemäßen Ermittlung der Lichtbogenspannung zugeführt wird. Die ermittelte Stromgröße des Stromkreises wird einer zweiten Auswerteeinheit AE2, zur Prüfung des Stromkriteriums - Überschreitung des dritten Schwellwertes SW3, zugeführt.

Die Ausgänge der beiden Auswerteeinheiten AE1, AE2 sind mit einer UND-Einheit & verknüpft, dessen Ausgang bei Erfüllung der Kriterien ein Störlichtbogenerkennungssignal SLES abgibt. Die drei Auswerteeinheiten können dabei als Teileinheiten bzw. Untereinheiten in einer Auswerteeinheit AE angeordnet sein.

Des Weiteren kann die Abgabe eines Störlichtbogenerkennungssignals erst dann erfolgen, wenn mindestens zweimal die Lichtbogenspannung oder/und das Stromkriterium den entsprechenden Schwellwert überschreiten. Analog kann auch eine dreimalige, viermalige, fünfmalige, usw. Überschreitung des Schwellwertes zur Abgabe eines Störlichtbogenerkennungssignales führen. So wird eine besonders sichere Auswertung und Erkennung eines Störlichtbogens erreicht.

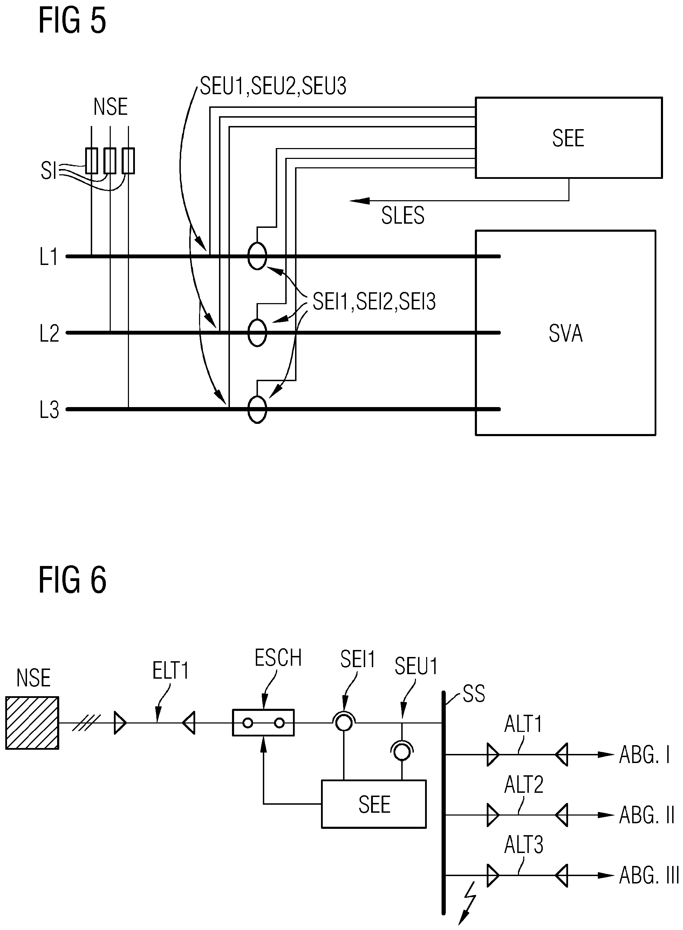

Figur 5 zeigt eine schematische Darstellung eines Übersichtsschaltbildes für eine Anlagenkonfiguration mit abgangsselektiver Störlichtbogenerkennungseinheit für die Erfassung von Störlichtbogen. Figur 5 zeigt eine NiederspannungsEinspeisung NSE, mit Sicherungen SI, denen Stromschienen bzw. Sammelschienen L1, L2, L3 für die Leiter eines Dreiphasen-Wechselstromnetzes bzw. Stromkreises folgen. Der Neutralleiter bzw. Nullleiter ist nicht dargestellt. Jeder der drei Stromschienen L1, L2, L3 ist jeweils ein Spannungssensor SEU1, SEU2, SEU3 und ein Stromsensor SEI1, SEI2, SEI3 zugeordnet. Die Stromschienen sind mit einer Schalt- oder/und Verteilanlage SVA verbunden. Die Spannungs- und Stromsensoren sind mit einer erfindungsgemäßen Störlichtbogenerkennungseinheit SEE verbunden, die eine erfindungsgemäße Auswerteeinheit AE aufweist. Diese weist einen Ausgang zur Abgabe eines Störlichtbogenerkennungssignals SLES auf. Die Spannungs- und Stromsensoren ermitteln Spannungswerte und Stromgrößen (Stromwert oder/und Stromwertänderung) der Sammelschienen L1, L2, L3 und führen sie der erfindungsgemäßen Störlichtbogenerkennungseinheit SEE zu. Die Sensoren sind dabei außerhalb Störlichtbogenerkennungseinheit angeordnet und mit dieser verbunden.

Figur 6 zeigt eine weitere schematische Darstellung eines Übersichtsschaltbildes für eine Anlagenkonfiguration mit zentraler Störlichtbogenerkennungseinheit für die Erfassung von Störlichtbogen. Figur 6 zeigt eine Niederspannungseinspeisung NSE, der ein Einspeise-Kabel ELT1 folgt, dem ein Einspeise-Schalter ESCH folgt, dem ein Stromsensor SEI1 und ein Spannungssensor SEU1 folgt, dem eine Sammelschien SS folgt. An der Sammelschiene SS sind 3 Abgänge ABG I ABG II und ABG III vorgesehen. Diesen ist je ein Abgangs-Kabel ALT1, ALT2, ALT3 zugeordnet. Die Sensoren SEI1, SEU1 sind mit einer Störlichtbogenerkennungseinheit SEE verbunden, dessen Ausgang wiederum mit dem Einspeise-Schalter ESCH verbunden ist. Der Einspeise-Schalter kann dabei ein Leistungsschalter sein. Bei Erkennung eines Störlichtbogens kann der elektrische Stromkreis, d.h. die Stromversorgung der Sammelschiene SS unterbrochen werden, wenn beispielsweise in einem der Abgänge ein Störlichtbogen auftritt.

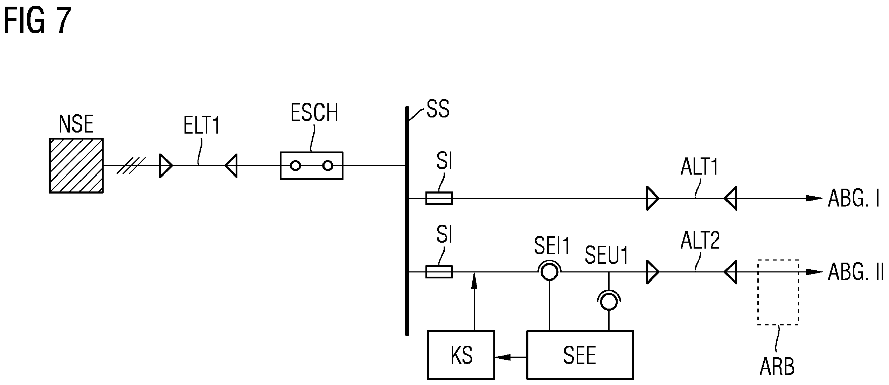

Figur 7 zeigt eine Darstellung gemäß Figur 6, mit dem Unterschied, dass die Sensoren im zweiten Abgang ABG II angeordnet sind, der zudem Sicherungen SI und einen Kurzschließer KS aufweist. Die Sensoren SEI1 und SEU1 erfassen Strom- und Spannungswerte des Abganges ABG II und geben diese an die Störlichtbogenerkennungseinheit SEE weiter. Erkennt die Störlichtbogenerkennungseinheit SEE einen Störlichtbogen, wird an ihrem Ausgang ein Störlichtbogenerkennungssignal abgegeben und zum Kurzschließer KS übertragen. Dieser schließt daraufhin den Abgang ABG II kurz, um den Störlichtbogen zu löschen.

Die Störlichtbogenerkennung gemäß Figur 6 oder 7 kann beispielsweise als mobiles System ausgeführt sein.

Die Erfindung soll im Folgenden nochmals erläutert werden.

Mit der Erfindung können Störlichtbögen, insbesondere parallele oder stromstarke, insbesondere in Niederspannungsschalt- und Verteilungsanlagen, erkannt werden. Erfindungsgemäß steht dazu insbesondere eine nummerischer Lösung bzw. Detektionsalgorithmus auf Grundlage der Auswertung von gemessenen Spannungs- und Stromwerten bzw. -signalen zur Verfügung. Für die Erkennung von Störlichtbögen wird die Spannung und der Strom bzw. Änderung des Stromes gemessen und Mithilfe einer erfindungsgemäßen Lichtbogenspannungsberechnung ein Störlichtbogen ermittelt. Aufgrund der in der Praxis notwendigen schnellen Lichtbogendetektion kann hierbei erfindungsgemäß eine außerordentlich schnelle zeitliche Auswertung zur Verfügung gestellt werden.

Mit dieser Erfindung können beispielsweise auf Basis einer zentralen Spannungs- und Strommessung an der Einspeisung stromstarke Störlichtbögen, beispielsweise in Schalt- und Verteileranlagen, z.B. in der Niederspannung, schnell detektiert werden.

Die Erfindung kann insbesondere vorteilhaft in bzw. im Zusammenwirken mit Leistungsschaltern oder Kurzschließern eingesetzt werden.

Eine aufwendige Installation von Lichtwellenleitern in Anlagen zur Störlichtbogenerkennung ist nicht erforderlich. Die Spannungs- / Strommessung kann zentral realisiert und ggf. synergetisch von weiteren Betriebsmitteln genutzt werden.

Im Weiteren ist eine Implementierung in vorhandene Schalt- und Verteileranalgen einfach möglich, da ein erfindungsgemäßes Detektionssystem beispielsweise lediglich zentral eingebaut werden kann und keine Installation in einzelnen, zu schützenden Zellen erforderlich ist.

Die Erfindung kann als Baugruppe mit zentraler Spannungs- und Stromermittlung realisiert sein.

Die bisher am Markt etablierten Detektionssysteme basieren auf einer optischen Fehlererkennung und weisen somit Potential zu einer Fehlauslösung durch die Einwirkung von Fremdlicht (z.B. Blitzlicht) auf. Bei der erfindungsgemäßen Lösung auf Grundlage einer Spannungs- und Strommessung ist dieses Gefahrenpotential nicht vorhanden.

Obwohl die Erfindung im Detail durch das Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Bezugszeichenliste

| | |
|---|---|
| A | Ampere |
| ABG I | Abgang I |
| ABG II | Abgang II |
| ABG III | Abgang III |
| ALT 1 | Abgangs-Kabel 1 |
| ALT 2 | Abgangs-Kabel 2 |
| ALT 3 | Abgangs-Kabel 3 |
| ARB | Arbeitsbereich |
| AE | Auswerteeinheit |
| AE1 | Erste Auswerte(teil)einheit |
| AE2 | Zweite Auswerte(teil)einheit |
| ELT1 | Einspeise-Kabel 1 |
| ESCH | Einspeise-Schalter, Leistungsschalter |
| I | elektrischer Strom |
| $i_{lb}$ | Lichtbogenstrom |
| im | Stromwert, gemessen |
| $i'_m$ | Wert der Änderung des Stromwertes |
| KS | Kurzschließer |
| $L_{BM}$ | Induktivität Verbraucher |
| $L_{EK}$ | Induktivität Einspeise-Kabel |
| L1 | Stromschiene, Leiter 1 |
| L2 | Stromschiene, Leiter 2 |
| L3 | Stromschiene, Leiter 3 |
| ms | Millisekunden |
| NSE | Niederspannungseinspeisung |
| $R_{BM}$ | Widerstand Verbraucher |
| $R_{EK}$ | Widerstand Einspeise-Kabel |
| SEE | Störlichtbogenerkennungseinheit |
| SEI1 | Stromsensor |
| SEI2 | Stromsensor |
| SEI3 | Stromsensor |
| SEU1 | Spannungssensor |
| SEU2 | Spannungssensor |
| SEU3 | Spannungssensor |
| SLES | Störlichtbogenerkennungssignal |
| SI | Sicherung |
| SS | Sammelschiene |

| | |
|---|---|
| SVA | Schalt- und Verteilanlage |
| SW1 | Schwellwert Lichtbogenspannung |
| SW2 | Schwellwert Spannung |
| SW3 | Schwellwert Stromfreigabe |
| SW4 | Schwellwert Lichtbogenspannung |
| t | Zeit |
| U | elektrische Spannung |
| $U_{LB}$, Ulb | Lichtbogenspannung |
| $u_m$ | Spannungswert, gemessen |
| $u_n$ | Spannungswert, Energiequelle / Netz |
| V | Volt |
| & | UND-Einheit |
| 1 | Schritt 1 - fortlauf. Berechnung Lichtbogenspannung |
| 2 | Schritt 2 - Schwellwertvergleich |
| 3 | Schritt 3 - Abgabe Störlichtbogenerkennungssignal |
| 4 | Schritt 4 - Kein Störlichtbogen |
| 100 | Energiequelle |
| 200 | Netzzugang / Einspeise-Kabel |
| 300 | Verbraucher / Betriebsmittel / Energiesenke |
| 400 | Lichtbogen |
| 500 | Überwachter Bereich |
| 600 | Meßpunkte |

**Patentansprüche**

1. Störlichtbogenerkennungseinheit für einen elektrischen Niederspannungsstromkreis, aufweisend
mindestens einen dem Stromkreis zugeordneten Spannungssensor, zur periodischen Ermittlung von elektrischen Spannungswerten ($u_m$) des Stromkreises,
mindestens einen dem Stromkreis zugeordneten Stromsensor, zur periodischen Ermittlung von elektrischen Stromgrößen des Stromkreises,
die beide mit einer Auswerteeinheit verbunden ist, und die derart ausgestaltet sind,
dass fortlaufend Wertepaare, aufweisend einen Spannungswert und eine Stromgröße, ermittelt werden,
dass ein Wertesatz mehrere Wertepaare ($t_S$) umfasst,
dass aus zwei Wertesätzen eine Lichtbogenspannung ($U_{LB}$) berechnet wird, die mit einem ersten Schwellwert (SW1) verglichen wird und bei dessen betragsmäßiger Überschreitung ein Störlichtbogenerkennungssignal abgegeben wird.

2. Störlichtbogenerkennungseinheit nach Patentanspruch 1,
**dadurch gekennzeichnet,**
**dass** aus drei Wertesätzen eine Lichtbogenspannung ($U_{LB}$) berechnet wird, die mit dem ersten Schwellwert (SW1) verglichen wird und bei dessen betragsmäßiger Überschreitung ein Störlichtbogenerkennungssignal abgegeben wird.

3. Störlichtbogenerkennungseinheit nach Patentanspruch 1 oder 2,
**dadurch gekennzeichnet,**
**dass** als elektrische Stromgröße entweder ein elektrischer Stromwert ($i_m$) oder/und ein Wert für die Änderung des elektrischen Stromes nach der Zeit ($i'_m$) ermittelt wird.

4. Störlichtbogenerkennungseinheit nach Patentanspruch 3,
**dadurch gekennzeichnet,**
**dass** im Falle der Ermittlung des elektrischen Stromwertes ($i_m$) daraus ein Wert für die Änderung des elektrischen Stromes nach der Zeit ($i'_m$) ermittelt wird oder
**dass** im Falle der Ermittlung des Wertes für die Änderung des elektrischen Stromes nach der Zeit ($i'_m$) daraus der elektrische Stromwert ($i_m$) ermittelt wird,
so dass das Wertepaar einen Spannungswert ($u_m$), einen Stromwert ($i_m$) und einen Wert für die Änderung des Stromes nach der Zeit ($i'_m$) aufweist.

**5.** Störlichtbogenerkennungseinheit nach einem der vorhergehenden Patentansprüche, **dadurch gekennzeichnet,** **dass** ein Wertepaar nur einem Wertesatz zugeordnet ist.

**6.** Störlichtbogenerkennungseinheit nach einem der vorhergehenden Patentansprüche, **dadurch gekennzeichnet,** **dass** jeder Wertesatz eine feste Anzahl Wertepaare ($t_s$) aufweist.

**7.** Störlichtbogenerkennungseinheit nach Patentanspruch 6, **dadurch gekennzeichnet,** **dass** fortwährend die Wertepaare einem Wertesatz zugeordnet werden, bis die feste Anzahl Wertepaare ($t_s$) erreicht ist, und die nachfolgenden Wertepaare dem nächsten Wertesatz zugeordnet werden.

**8.** Störlichtbogenerkennungseinheit nach einem der vorhergehenden Patentansprüche, **dadurch gekennzeichnet,** **dass** die elektrischen Spannungswerte oder/und Stromgrößen mit einem festen Zeitabstand (dt) ermittelt werden.

**9.** Störlichtbogenerkennungseinheit nach einem der vorhergehenden Patentansprüche, **dadurch gekennzeichnet,** **dass** die Auswerteeinheit derart ausgestaltet ist, dass die Berechnung der Lichtbogenspannung ($U_{LB}$) mit Hilfe einer Integralgleichung oder deren Lösung durchgeführt wird.

**10.** Störlichtbogenerkennungseinheit nach Patentanspruch 9, **dadurch gekennzeichnet,** **dass** aus einem Wertesatz mindestens einer der folgenden Terme berechnet wird:

a) ein Zeit-Spannungssummen-Produkt ($u_S$), gebildet aus dem Zeitabstand (dt) und der Summe der Spannungswerte ($u_m$), wobei die Summe der Spannungswerte durch den halben ersten Spannungswert, den halben letzten Spannungswert und der Summe der übrigen Spannungswerte des Wertesatzes gebildet wird;
b) ein Zeit-Stromsummen-Produkt ($i_S$), gebildet aus dem Zeitabstand (dt) und der Summe der Stromwerte, wobei die Summe des Stromwerte durch den halben ersten Stromwert, den halben letzten Stromwert und der Summe des übrigen Stromwerte des Wertesatzes gebildet wird;
c) ein Zeit-Stromänderungswert-Produkt ($i'_S$), gebildet aus dem Zeitabstand (dt) und der Summe der Werte für die Änderung des Stromes nach der Zeit, wobei die Summe der Werte für die Änderung des Stromes nach der Zeit durch den halben ersten Wert, den halben letzten Wert und der Summe der übrigen Werte des Wertesatzes gebildet wird;
d) ein Zeit-Vorzeichenwert-Produkt ($s_S$), gebildet aus dem Zeitabstand (dt) und der Summe der Vorzeichenwerte der Stromwerte, wobei ein Vorzeichenwert den Wert plus Eins bei positiven Stromwert, minus Eins bei negativen Stromwert und Null bei einem Stromwert von Null annimmt, wobei die Summe der Vorzeichenwerte aus dem halben Vorzeichenwert des ersten Stromwertes, dem halben Vorzeichenwert des letzten Stromwertes und der Summe der Vorzeichenwerte der übrigen Stromwerte gebildet wird.

**11.** Störlichtbogenerkennungseinheit nach Patentanspruch 10, **dadurch gekennzeichnet,** **dass** ein Vorzeichenwert des Stromwertes den Wert Null annimmt, wenn der Betrag des Spannungswertes dieses Wertepaares einen zweiten Schwellwert (SW2) unterschreitet.

**12.** Störlichtbogenerkennungseinheit nach Patentanspruch 10 oder 11, **dadurch gekennzeichnet,** **dass** für zwei aufeinanderfolgende Wertesätze jeweils:

ein erstes ($u_{S1}$) und ein zweites ($u_{S2}$) Zeit-Spannungssummen-Produkt,
ein erstes ($i_{S1}$) und ein zweites ($i_{S2}$) Zeit-Stromsummen-Produkt,
ein erstes ($i'_{S1}$) und ein zweites ($i'_{S2}$) Zeit-Stromänderungswert-Produkt,
ein erstes ($s_{S1}$) und ein zweites ($s_{S2}$) Zeit-Vorzeichenwert-Produkt berechnet wird.

**13.** Störlichtbogenerkennungseinheit nach Patentanspruch 10 oder 11, **dadurch gekennzeichnet,** **dass** für drei aufeinanderfolgende Wertesätze jeweils:

ein erstes ($u_{S1}$), ein zweites ($u_{S2}$) und ein drittes ($u_{S3}$) Zeit-Spannungssummen-Produkt,

ein erstes ($i_{S1}$)' ein zweites ($i_{S2}$), und ein drittes ($i_{S3}$) Zeit-Stromsummen-Produkt,

ein erstes ($i'_{S1}$), ein zweites ($i'_{S2}$) und ein drittes ($i'_{S3}$) Zeit-Stromänderungswert-Produkt,

ein erstes ($s_{S1}$), ein zweites ($s_{S2}$) und ein drittes ($s_{S3}$) Zeit-Vorzeichenwert-Produkt berechnet wird.

**14.** Störlichtbogenerkennungseinheit nach Patentanspruch 12 oder 13,
**dadurch gekennzeichnet,**
**dass** für die Berechnung der Lichtbogenspannung ($U_{LB}$) mindestens einer der folgenden Terme gebildet wird:

ein erstes Produkt (P1), gebildet aus dem dritten Zeit-Spannungssummen-Produkt ($u_{S3}$) und dem zweiten Zeit-Stromsummen-Produkt ($i_{S2}$),

ein zweites Produkt (P2), gebildet aus dem zweiten Zeit-Spannungssummen-Produkt ($u_{S2}$) und dem dritten Zeit-Stromsummen-Produkt ($i_{S3}$),

ein drittes Produkt (P3), gebildet aus dem zweiten Zeit-Stromänderungswert-Produkt ($i'_{S2}$) und dem ersten Zeit-Stromsummen-Produkt ($i_{S1}$),

ein viertes Produkt (P4), gebildet aus dem ersten Zeit-Stromänderungswert-Produkt ($i'_{S1}$) und dem zweiten Zeit-Stromsummen-Produkt ($i_{S2}$),

ein fünftes Produkt (P5), gebildet aus dem zweiten Zeit-Spannungssummen-Produkt ($u_{S2}$) und dem ersten Zeit-Stromsummen-Produkt ($i_{S1}$),

ein sechstes Produkt (P6), gebildet aus dem ersten Zeit-Spannungssummen-Produkt ($u_{S1}$) und dem zweiten Zeit-Stromsummen-Produkt ($i_{S2}$),

ein siebtes Produkt (P7), gebildet aus dem dritten Zeit-Stromänderungswert-Produkt ($i'_{S3}$) und dem zweiten Zeit-Stromsummen-Produkt ($i_{S2}$),

ein achtes Produkt (P8), gebildet aus dem zweiten ZeitStromänderungswert-Produkt ($i'_{S2}$) und dem dritten Zeit-Stromsummen-Produkt ($i_{S3}$),

ein neuntes Produkt (P9), gebildet aus dem ersten Zeit-Vorzeichenwert-Produkt ($s_{S1}$) und dem zweiten Zeit-Stromsummen-Produkt ($i_{S2}$),

ein zehntes Produkt (P10), gebildet aus dem zweiten Zeit-Vorzeichenwert-Produkt ($s_{S2}$) und dem ersten Zeit-Stromsummen-Produkt ($i_{S1}$),

ein elftes Produkt (P11), gebildet aus dem zweiten Zeit-Vorzeichenwert-Produkt ($s_{S2}$) und dem dritten Zeit-Stromsummen-Produkt ($i_{S3}$),

ein zwölftes Produkt (P12), gebildet aus dem dritten Zeit-Vorzeichenwert-Produkt ($s_{S3}$) und dem zweiten Zeit-Stromsummen-Produkt ($i_{S2}$).

**15.** Störlichtbogenerkennungseinheit nach Patentanspruch 14,
**dadurch gekennzeichnet,**
**dass** für die Berechnung der Lichtbogenspannung ($U_{LB}$) mindestens einer der folgenden Terme gebildet wird:

eine erste Differenz (D1), dessen Minuend das erste Produkt (P1) und dessen Subtrahend das zweite Produkt (P2) ist,

eine zweite Differenz (D2), dessen Minuend das dritte Produkt (P3) und dessen Subtrahend das vierte Produkt (P4) ist,

eine dritte Differenz (D3), dessen Minuend das fünfte Produkt (P5) und dessen Subtrahend das sechste Produkt (P6) ist,

eine vierte Differenz (D4), dessen Minuend das siebte Produkt (P7) und dessen Subtrahend das achte Produkt (P8) ist

eine fünfte Differenz (D5), dessen Minuend das neunte Produkt (P9) und dessen Subtrahend das zehnte Produkt (P10) ist,

eine sechste Differenz (D6), dessen Minuend das elfte Produkt (P11) und dessen Subtrahend das zwölfte Produkt (P12) ist.

**16.** Störlichtbogenerkennungseinheit nach Patentanspruch 15,
**dadurch gekennzeichnet,**
**dass** für die Berechnung der Lichtbogenspannung ($U_{LB}$) mindestens einer der folgenden Terme gebildet wird:

ein dreizehntes Produkt (P13), gebildet aus der ersten Differenz (D1) und der zweiten Differenz (D2),

ein vierzehntes Produkt (P14), gebildet aus der dritten Differenz (D3) und der vierten Differenz (D4),

ein fünfzehntes Produkt (P15), gebildet aus der fünften Differenz (D5) und der vierten Differenz (D4),

ein sechzehntes Produkt (P16), gebildet aus der sechsten Differenz (D6) und der zweiten Differenz (D2).

17. Störlichtbogenerkennungseinheit nach Patentanspruch 16,
**dadurch gekennzeichnet,**
**dass** für die Berechnung der Lichtbogenspannung ($U_{LB}$) mindestens einer der folgenden Terme gebildet wird:

eine siebte Differenz (D7), dessen Minuend das dreizehnte Produkt (P13) und dessen Subtrahend das vierzehnte Produkt (P14) ist,
eine achte Differenz (D8), dessen Minuend das fünfzehnte Produkt (P15) und dessen Subtrahend das sechzehnte Produkt (P16) ist.

18. Störlichtbogenerkennungseinheit nach Patentanspruch 17, **dadurch gekennzeichnet,**
**dass** die Lichtbogenspannung ($U_{LB}$) ein Quotient ist,
dessen Dividend Terme der siebten Differenz (D7) aufweist und dessen Divisor Terme der achten Differenz (D8) aufweist.

19. Störlichtbogenerkennungseinheit nach einem der Patentansprüche 12 bis 17,
**dadurch gekennzeichnet,**
**dass** für die Berechnung der Lichtbogenspannung ($U_{LB}$) mindestens einer der folgenden Terme gebildet wird:

ein siebzehntes Produkt (P17), gebildet aus dem ersten Zeit-Stromsummen-Produkt ($i_{S1}$) und der Anzahl der Wertepaare des zweiten Wertesatzes ($t_{S2}$),
ein achtzehntes Produkt (P18), gebildet aus dem zweiten Zeit-Stromsummen-Produkt ($i_{S2}$) und der Anzahl der Wertepaare des ersten Wertesatzes ($t_{S1}$),
eine neunte Differenz (D9), dessen Minuend das siebzehnte Produkt (P17) und dessen Subtrahend das achtzehnte Produkt (P18) ist,
eine zehnte Differenz (D10), dessen Minuend das zehnte Produkt (P10) und dessen Subtrahend das neunte Produkt (P9) ist.

20. Störlichtbogenerkennungseinheit nach Patentanspruch 19, **dadurch gekennzeichnet,**
**dass** die Lichtbogenspannung ($U_{LB}$) ein Quotient ist,
dessen Dividend Terme der dritten Differenz (D3) aufweist und dessen Divisor Terme der neunten Differenz (D9) aufweist.

21. Störlichtbogenerkennungseinheit nach Patentanspruch 19, **dadurch gekennzeichnet,**
**dass** die Lichtbogenspannung ($U_{LB}$) ein Quotient ist,
dessen Dividend Terme der dritten Differenz (D3) aufweist und dessen Divisor Terme der zehnten Differenz (D10) aufweist.

22. Störlichtbogenerkennungseinheit nach einem der Patentansprüche 12 bis 17 oder 19,
**dadurch gekennzeichnet,**
**dass** für die Berechnung der Lichtbogenspannung ($U_{LB}$) mindestens einer der folgenden Terme gebildet wird:

ein neunzehntes Produkt (P19), gebildet aus dem zweiten Zeit-Spannungssummen-Produkt ($u_{S2}$) und dem ersten Zeit-Stromänderungswert-Produkt ($i'_{S1}$),
ein zwanzigstes Produkt (P20), gebildet aus dem ersten Zeit-Spannungssummen-Produkt ($u_{S1}$) und dem zweiten Zeit-Stromänderungswert-Produkt ($i'_{S2}$),
ein einundzwanzigstens Produkt (P21), gebildet aus dem ersten Zeit-Stromänderungswert-Produkt ($i'_{S1}$) und der Anzahl der Wertepaare des zweiten Wertesatzes ($t_{S2}$),
ein zweiundzwanzigstens Produkt (P22), gebildet aus dem zweiten Zeit-Stromänderungswert-Produkt ($i'_{S2}$) und der Anzahl der Wertepaare des ersten Wertesatzes ($t_{S1}$),
eine elfte Differenz (D11), dessen Minuend das neunzehnte Produkt (P19) und dessen Subtrahend das zwanzigste Produkt (P20) ist,
eine zwölfte Differenz (D12), dessen Minuend das einundzwanzigste Produkt (P21) und dessen Subtrahend das zweiundzwanzigste Produkt (P22) ist.

23. Störlichtbogenerkennungseinheit nach Patentanspruch 22, **dadurch gekennzeichnet,**
**dass** die Lichtbogenspannung ($U_{LB}$) ein Quotient ist,

dessen Dividend Terme der elften Differenz (D11) aufweist und dessen Divisor Terme der zwölften Differenz (D12) aufweist.

24. Störlichtbogenerkennungseinheit nach einem der Patentansprüche 12 bis 17, 19 oder 22, **dadurch gekennzeichnet,** **dass** für die Berechnung der Lichtbogenspannung ($U_{LB}$) mindestens einer der folgenden Terme gebildet wird:

ein dreiundzwanzigstes Produkt (P23), gebildet aus dem ersten Zeit-Stromänderungswert-Produkt ($i'_{S1}$) und dem zweiten Zeit-Vorzeichenwert-Produkt ($s_{S2}$),
ein vierundzwanzigstes Produkt (P24), gebildet aus dem zweiten Zeit-Stromänderungswert-Produkt ($i'_{S2}$) und dem ersten Zeit-Vorzeichenwert-Produkt ($s_{S1}$).
eine dreizehnte Differenz (D13), dessen Minuend das dreiundzwanzigste Produkt (P23) und dessen Subtrahend das vierundzwanzigste Produkt (P24) ist.

25. Störlichtbogenerkennungseinheit nach Patentanspruch 24, **dadurch gekennzeichnet,** **dass** die Lichtbogenspannung ($U_{LB}$) ein Quotient ist, dessen Dividend Terme der elften Differenz (D11) aufweist und dessen Divisor Terme der dreizehnten Differenz (D13) aufweist.

26. Störlichtbogenerkennungseinheit nach einem der Patentansprüche 12 bis 17, 19, 22 oder 24, **dadurch gekennzeichnet,** **dass** für die Berechnung der Lichtbogenspannung ($U_{LB}$) mindestens einer der folgenden Terme gebildet wird:

ein fünfundzwanzigstes Produkt (P25), gebildet aus dem dritten Zeit-Stromänderungswert-Produkt ($i'_{S3}$) und dem ersten Zeit-Stromsummen-Produkt ($i_{S1}$),
ein sechsundzwanzigstes Produkt (P26), gebildet aus dem ersten Zeit-Stromänderungswert-Produkt ($i'_{S1}$) und dem dritten Zeit-Stromsummen-Produkt ($i_{S3}$),
ein siebenundzwanzigstes Produkt (P27), gebildet aus dem dritten Zeit-Spannungssummen-Produkt ($u_{S3}$) und dem ersten Zeit-Stromsummen-Produkt ($i_{S1}$),
ein achtundzwanzigstes Produkt (P28), gebildet aus dem ersten Zeit-Spannungssummen-Produkt ($u_{S1}$) und dem dritten Zeit-Stromsummen-Produkt ($i_{S3}$),
ein neunundzwanzigstens Produkt (P29), gebildet aus dem dritten Zeit-Stromsummen-Produkt ($i_{S3}$) und der Anzahl der Wertepaare des ersten Wertesatzes ($t_{S1}$),
ein dreizigstes Produkt (P30), gebildet aus dem ersten Zeit-Stromsummen-Produkt ($i_{S1}$) und der Anzahl der Wertepaare des dritten Wertesatzes ($t_{S3}$),
eine vierzehnte Differenz (D14), dessen Minuend das fünfundzwanzigste Produkt (P25) und dessen Subtrahend das sechsundzwanzigste Produkt (P26) ist,
eine fünfzehnte Differenz (D15), dessen Minuend das siebenundzwanzigste Produkt (P27) und dessen Subtrahend das achtundzwanzigste Produkt (P28) ist,
eine sechzehnte Differenz (D16), dessen Minuend das neunundzwanzigste Produkt (P29) und dessen Subtrahend das dreizigste Produkt (P30) ist,
eine siebzehnte Differenz (D17), dessen Minuend das achtzehnte Produkt (P18) und dessen Subtrahend das siebzehnte Produkt (P17) ist.

27. Störlichtbogenerkennungseinheit nach einem der Patentansprüche 12 bis 17, 19, 22, 24 oder 26, **dadurch gekennzeichnet,** **dass** für die Berechnung der Lichtbogenspannung ($U_{LB}$) mindestens einer der folgenden Terme gebildet wird:

ein einunddreißigstes Produkt (P31), gebildet aus der dritten Differenz (D3) und der vierzehnten Differenz (D14),
ein zweiunddreißigstes Produkt (P32), gebildet aus der zweiten Differenz (D2) und der fünfzehnten Differenz (D15),
ein dreiunddreißigstes Produkt (P33), gebildet aus der zweiten Differenz (D2) und der sechzehnten Differenz (D16),
ein vierunddreißigstes Produkt (P34), gebildet aus der siebzehnten Differenz (D17) und der vierzehnten Differenz (D14),
eine achtzehnte Differenz (D18), dessen Minuend das einunddreißigste Produkt (P31) und dessen Subtrahend das zweiunddreißigste Produkt (P32) ist,
eine neunzehnte Differenz (D19), dessen Minuend das dreiunddreißigste Produkt (P33) und dessen Subtrahend das vierunddreißigste Produkt (P34) ist.

28. Störlichtbogenerkennungseinheit nach Patentanspruch 27, **dadurch gekennzeichnet,**
**dass** die Lichtbogenspannung ($U_{LB}$) ein Quotient ist,
dessen Dividend Terme der achtzehnten Differenz (D18) aufweist und dessen Divisor Terme der neunzehnten Differenz (D19) aufweist.

29. Störlichtbogenerkennungseinheit nach Patentanspruch 12 bis 28,
**dadurch gekennzeichnet,**
**dass** die Lichtbogenspannung ($U_{LB}$) auf den Wert Null gesetzt wird, wenn die Summe des ersten ($s_{S1}$) und zweiten ($s_{S2}$) Zeit-Vorzeichenwert-Produkts oder die Summe des ersten ($s_{S1}$), zweiten ($s_{S2}$) und dritten ($s_{S3}$) Zeit-Vorzeichenwert-Produkts gleich Null ist.

30. Störlichtbogenerkennungseinheit nach einem der vorhergehenden Patentansprüche,
**dadurch gekennzeichnet,**
**dass** die Auswerteeinheit derart ausgestaltet ist, dass ein Störlichtbogenerkennungssignal (SLES) nur dann abgegeben wird, wenn die Stromgröße, insbesondere der Stromwert, einen dritten Schwellwert (SW3) überschreitet.

31. Leistungsschalter, aufweisend eine Störlichtbogenerkennungseinheit nach einem der Patentansprüche 1 bis 30, die mit dem Leistungsschalter verbunden ist und die derart ausgestaltet sind, dass bei einem Störlichtbogenerkennnungssignal der elektrische Stromkreis durch den Leistungsschalter unterbrochen wird.

32. Kurzschließer, aufweisend eine Störlichtbogenerkennungseinheit nach einem der Patentansprüche 1 bis 30, die mit dem Kurzschließer verbunden ist und die derart ausgestaltet sind, dass bei einem Störlichtbogenerkennungssignal der elektrische Stromkreis durch den Kurzschließer kurzgeschlossen wird, um ein Löschen des Störlichtbogen zu bewirken.

33. Verfahren zur Störlichtbogenerkennung für einen elektrischen Niederspannungsstromkreis, bei dem periodisch elektrische Spannungswerte und Stromgrößen des Stromkreises ermittelt werden,
so dass fortlaufend Wertepaare, aufweisend einen Spannungswert und eine Stromgröße, vorliegen,
dass ein Wertesatz mehrere Wertepaare umfasst,
dass aus zwei Wertesätzen eine Lichtbogenspannung ($U_{LB}$) berechnet wird, die mit einem ersten Schwellwert (SW1) verglichen wird und bei dessen Überschreitung ein Störlichtbogenerkennungssignal abgegeben wird.

## FIG 1

## FIG 2

## FIG 3

## FIG 4

# FIG 5

# FIG 6

FIG 7

EP 3 252 902 A1

**Europäisches Patentamt**
**European Patent Office**
**Office européen des brevets**

## EUROPÄISCHER RECHERCHENBERICHT

Nummer der Anmeldung

EP 17 17 1304

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | EP 2 916 455 A1 (SIEMENS AG [DE]) 9. September 2015 (2015-09-09) * Zusammenfassung; Ansprüche 1-4 * ----- | 1-33 | INV. H02H1/00 G01R31/12 |
| A | EP 2 424 059 A2 (GEN ELECTRIC [US]) 29. Februar 2012 (2012-02-29) * Zusammenfassung; Ansprüche 1,7,12 * ----- | 1-33 | |
| A | US 7 627 400 B2 (AIRBUS FRANCE [FR]) 1. Dezember 2009 (2009-12-01) * Zusammenfassung; Ansprüche 1-14 * ----- | 1-33 | |
| A | DE 10 2004 056436 A1 (ESW EXTEL SYSTEMS WEDEL GES [DE]) 1. Juni 2006 (2006-06-01) * Zusammenfassung; Ansprüche 1-37 * ----- | 1-33 | |

**RECHERCHIERTE SACHGEBIETE (IPC)**

H02H
G01R

Der vorliegende Recherchenbericht wurde für alle Patentansprüche erstellt

| Recherchenort | Abschlußdatum der Recherche | Prüfer |
|---|---|---|
| München | 19. Oktober 2017 | Lehnberg, Christian |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
...........................................................................
& : Mitglied der gleichen Patentfamilie, übereinstimmendes
    Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 17 17 1304

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-10-2017

| Im Recherchenbericht angeführtes Patentdokument | Datum der Veröffentlichung | Mitglied(er) der Patentfamilie | Datum der Veröffentlichung |
|---|---|---|---|
| EP 2916455 A1 | 09-09-2015 | CN 104898008 A<br>DE 102014204253 A1<br>EP 2916455 A1 | 09-09-2015<br>10-09-2015<br>09-09-2015 |
| EP 2424059 A2 | 29-02-2012 | CN 102435917 A<br>EP 2424059 A2<br>JP 5923254 B2<br>JP 2012044861 A<br>KR 20120018729 A<br>US 2012044600 A1 | 02-05-2012<br>29-02-2012<br>24-05-2016<br>01-03-2012<br>05-03-2012<br>23-02-2012 |
| US 7627400 B2 | 01-12-2009 | AT 389886 T<br>BR PI0515672 A<br>CA 2576916 A1<br>CN 101027565 A<br>DE 602005005516 T2<br>EP 1815260 A1<br>FR 2876187 A1<br>JP 5530594 B2<br>JP 2008514943 A<br>RU 2007115918 A<br>RU 2009145739 A<br>US 2008033602 A1<br>WO 2006037874 A1 | 15-04-2008<br>29-07-2008<br>13-04-2006<br>29-08-2007<br>16-04-2009<br>08-08-2007<br>07-04-2006<br>25-06-2014<br>08-05-2008<br>10-11-2008<br>20-06-2011<br>07-02-2008<br>13-04-2006 |
| DE 102004056436 A1 | 01-06-2006 | CA 2527086 A1<br>DE 102004056436 A1<br>FR 2878380 A1<br>GB 2421372 A<br>US 2006109009 A1 | 19-05-2006<br>01-06-2006<br>26-05-2006<br>21-06-2006<br>25-05-2006 |

EPO FORM P0461

Für nähere Einzelheiten zu diesem Anhang : siehe Amtsblatt des Europäischen Patentamts, Nr.12/82